# EUROPÄISCHE PATENTSCHRIFT

(11) **EP 0 956 626 B1**
(45) Veröffentlichungstag und Bekanntmachung des Hinweises auf die Patenterteilung: **04.06.2003**
(21) Anmeldenummer: 98907875.3
(22) Anmeldetag: 29.01.1998
(51) Int. Cl.: H01S 5/32

(54) **KANTENEMITTIERENDES HALBLEITERLASER-BAUELEMENT**
EDGE EMITTING SEMI-CONDUCTOR LASER COMPONENT
COMPOSANT LASER A SEMICONDUCTEUR A EMISSION LATERALE

(30) Priorität: 31.01.1997 DE 19703612
(43) Veröffentlichungstag der Anmeldung: 17.11.1999
(73) Patentinhaber: Infineon Technologies AG, 81669 München (DE)
(72) Erfinder: LANDWEHR, Gottfried, D-97074 Würzburg (DE); KEIM, Markus, D-97072 Würzburg (DE); REUSCHER, Günter, D-97074 Würzburg (DE); LITZ, Thomas, D-97074 Würzburg (DE); BARON, Thierry, D-97218 Gerbrunn (DE); FISCHER, Frank, D-97074 Würzburg (DE); LUGAUER, Hans-Jürgen, D-97218 Gerbrunn (DE)
(74) Vertreter: Maikowski, Michael, Dipl.-Ing. Dr.
(86) Internationale Anmeldenummer: DE9800264
(87) Internationale Veröffentlichungsnummer: WO98034307

(56) Entgegenhaltungen:
- EP-A- 0 709 939
- WO-A-97/20353
- US-A- 5 338 944
- SUGG A R ET AL: "N-P-(P+-N+)-N ALYGA1-YAS-GAAS-INXGA1-XAS QUANTUM-WELL LASER WITH P+-N+ GAAS-INGAAS TUNNEL CONTACT ON N-GAAS" APPLIED PHYSICS LETTERS, Bd. 62, Nr. 20, 17.Mai 1993, Seiten 2510-2512, XP000303799
- H. HILLMER ET AL: "carrier and photon dynamics in transversally asymmetric high spedd algaas-InP MQW lasers" PHYSICS AND SIMULATION OF OPTOELECTRONIC DEVICES IV, SPIE, Bd. 2693, Januar 1996, Seiten 352-368, XP002068164 in der Anmeldung erwähnt
- J.J. WIERER ET AL: "Buried tunnelcontact junction AlGaAs-GaAs-InGaAs quantum well heterostructure lasers with oxide defined lateral czrrents" APPLIED PHYSICS LETTERS., Bd. 71, Nr. 16, 20.Oktober 1997, NEW YORK US, Seiten 2286-2288, XP002068165

## Beschreibung

Die Erfindung bezieht sich auf ein unipolares Halbleiterlaser-Bauelement mit einem zur Erzeugung einer elektromagnetischen Strahlung geeigneten Halbleiterkörper mit einem Heterosruktur-Aufbau, insbesondere einem SCH(Separate Confinement Heterostructure)-Aufbau, bei dem über einem Halbleitersubstrat eine zwischen einer ersten äußeren Deckschicht eines ersten Leitungstyps und einer zweiten äußeren Deckschicht des ersten Leitungstyps angeordnete aktive Schichtenfolge mit einer Quantentrogstruktur (= aktive Zone) vorgesehen ist, innerhalb der bei Stromfluss durch den Halbleiterkörper die elektromagnetische Strahlung erzeugt wird. Die Deckschichten weisen einen niedrigeren Brechungsindex auf als die aktive Schichtenfolge, wodurch im Betrieb eine erzeugte optische Welle zwischen den Deckschichten eingeschlossen wird.

In der Veröffentlichung H. Hillmer, A. Greiner, F. Steinhagen, H. Burkhard, R. Loesch, W. Schlapp., T. Kuhn, in Physics and Simulation of Optoelectronic Devices IV, SPIE Vol.2693 (1996) S. 352-368, ist eine Laserdiode beschrieben, bei welcher auf einem Halbleitersubstrat aus semiisolierendem oder n-leitendem InP eine n-leitende Deckschicht aus InP, darauf eine aktive Schichtfolge aus InGaAs/AlInGaAs und eine weitere Deckschicht aus p-leitendem InAlAs aufgebracht ist. Die aktive Zone besteht aus InGaAs-Mehrfachquantentrögen (MQW), die in AlInGaAs-Barrieren und AlInGaAs-Wellenleiterschichten eingebettet sind. Die AlInGaAs-Wellenleiterschichten sind beide p-leitend, jedoch mit p=5*10¹⁷ cm⁻³ geringer dotiert als die Deckschichten aus InP (n=2*10¹⁸cm⁻³) bzw. InAlAs (p=2*10¹⁸cm⁻³). Bei dem in Hillmer et al. angegebenen Aufbau handelt es sich um eine sogenannte Separate-Confinement-Heterostruktur (SCH) bei welcher Elektronen und Löcher in eine aktive Zone durch einen pn-Übergang injiziert werden, der im Wesentlichen aus den Deckschichten, im beschriebenen Fall n-InP und p-InAlAs, gebildet ist. Die erzeugte optische Welle wird unabhängig vom Ladungsträgereinschluss in den Quantentrögen durch den Wellenleiter geführt, der von den Deckschichten mit niedrigerem Brechungsindex umschlossen ist. Im speziellen Fall ist die aktive MQW-Zone nicht symmetrisch, d. h. mittig in den Wellenleiter eingebracht. Der Wellenleiter auf der der p-leitenden Deckschicht zugewandten Seite ist verkürzt, um den Transport von Löchern in den Quantentrog zu beschleunigen, die prinzipiell eine deutlich geringere Beweglichkeit besitzen als Elektronen. Damit wird eine verbesserte Modulierbarkeit erzielt, die im Wesentlichen durch den Transport von weniger beweglichen Löchern innerhalb des mäßig dotierten Wellenleiters und den Elektroneneinfang in der MQW-Struktur bestimmt wird.

Die prinzipiellen Strukturen von Quantentrog- und MQW-Halbleiterlasern und des SCH-Aufbaus sind beispielsweise in W. Buldau, Halbleiter-Optoelektronik, Hanser-Verlag, München, Wien, 1995, S. 182-187, beschrieben und werden von daher an dieser Stelle nicht näher erläutert.

Bei den bisher untersuchten Lasern, basierend auf den Materialien InGaAsP und AlInGaAs ist die Löcherbeweglichkeit in der Wellenleiterschicht deutlich kleiner als die Beweglichkeit von Elektronen.

Für eine hohe Datenübertragungsrate bei Wellenlängen von 1,3 µm und 1,55 µm im optischen Fenster herkömmlicher Glasfasern tritt eine Begrenzung in der Hochfrequenz-Modulierbar-keit durch den Drifttransport von weniger beweglichen Löchern in den Quantentrog hinein und den Elektroneneinfang in der MQW-Struktur auf.

Durch die oben genannte Verkürzung der p-seitigen Wellenleiterschicht kann die Transportlänge für Löcher im Wellenleiter verkürzt werden. Die Driftgeschwindigkeit wird jedoch durch das angelegte elektrische Feld und die schlechte Beweglichkeit bestimmt.

Die Aufgabe der vorliegenden Erfindung besteht darin, ein Halbleiterlaser-Baueiement der eingangs genannten Art zu entwickeln, das im Vergleich zu dem oben beschriebenen bekannten Halbleiterlaser-Bauelement eine verbesserte Funktionsfähigkeit aufweist. Es soll insbesondere ein Halbleiterlaser mit verbesserter Hochfrequenzmodulierbarkeit bei Wellenlängen im Bereich zwischen 1,3 µm und 1,55 µm zur Verfügung gestellt werden.

Diese Aufgabe wird durch ein Halbleiterlaser-Bauelement mit den Merkmalen des Anspruches 1 gelöst. Weitere vorteilhafte Ausgestaltungen ergeben sich aus den zugehörigen Unteransprüchen.

Erfindungsgemäß ist vorgesehen, dass zwischen der aktiven Schichtenfolge und der zweiten äußeren Deckschicht eine erste hochdotierte entartete Übergangsschicht (z. B. n' oder p⁺) eines dem ersten Leitungstyp entgegengesetzten zweiten Leitungstyps und eine zweite hochdotierte entartete Übergangsschicht (z. B. p⁺ bzw. n⁺) des ersten Leitungstyps vorgesehen ist, derart, daß die zweite hochdotierte entartete Übergangsschicht zwischen der ersten hochdotierten entarteten Übergangsschicht und der zweiten äußeren Deckschicht angeordnet ist.

Unter hoch n-dotiert (oder n⁺-dotiert) und hoch p-dotiert (oder p⁺-dotiert), also entarteter Dotierung, ist jeweils vorteilhafterweise eine Dotierstoff-Konzentration von ≥ 10¹⁷ cm⁻³ zu verstehen.

Die n⁺p⁺-Schichtenfolge wirkt als "Lochinjektor", durch welchen Elektronen nahe der aktiven Zone in Löcher umgewandelt werden und im elektrischen Feld beschleunigt werden. Folglich werden durch diese relativ zum Bauteil rückwärtsgepolte n⁺p⁺-Schichtenfolge Ladungsträger innerhalb eines internen elektrichen Feldes in der n⁺p⁺-Schichtenfolge beschleunigt und rascher in die aktive Zone injiziert. Die n⁺p⁺-Schichtenfolge fungiert als Quelle für Ladungsträger innerhalb der Deckschichten.

In dem Ladungsträgerinjektor kommt es in der Distanz einer Debye-Länge um den Übergang herum zu einer echten Umkehr des Leitungstyps, d. h. das Fermi-Niveau wird durch n-Dotierung auf einer Seite der Diode ins Leitungsband gebracht und auf der gegenüberliegenden Seite ziehen Löcher durch p-Dotierung das Fermi-Niveau ins Valenzband (" Entartung"). Durch die sehr schmale Raumladungszone von wenigen Angström zwischen diesen entartet dotierten Gebieten des Ladungsträgerinjektors kann es unter Rückwärtspolung zu Interbandtunneln von Elektronen aus dem Valenzband des p-dotierten Halbleiters in Zustände des Leitungsbandes des n-dotierten Halbleiters kommen, wodurch im p-dotierten Gebiet Löcher entstehen.

Bei einer bevorzugten Ausführungsform des erfindungsgemäßen Halbleiterlaser-Bauelements kann zwischen der ersten hochdotierten entarteten Übergangsschicht und der zweiten hochdotierten entarteten Übergangsschicht eine im Vergleich zu den Übergangsschichten geringer dotierte Barriereschicht eines beliebigen Ladungstyps angeordnet sein. Diese Barriereschicht kann eine Barriere für Elektronen bilden, die über die aktive Zone hinauslaufen.

Bei einer weiteren bevorzugten Ausführungsform ist zwischen der ersten hochdotierten entarteten Übergangsschicht und der Quantentrogstruktur eine dünne, im Vergleich zu den Übergangsschichten niedriger dotierte Barriereschicht für Elektronen angeordnet, die verhindern soll, dass Elektronen, die über die aktive Zone hinaus driften, in die hochdotierten entarteten Übergangsschichten (p⁺n⁺-Struktur) ablaufen.

Bei dem erfindungsgemäßen Halbleiterlaser-Bauelement, insbesondere bei den zuletzt genannten beiden Ausführungsformen, werden Ladungsträger in einem elektrischen Feld beschleunigt, das sich bei Durchlasspolung der Laserdiode in der Verarmungszone der hochdotierten entarteten Übergangsschichten (= p⁺ (n) n⁺-Diode) aufbaut, die in diesem Fall in Sperrichtung gepolt ist. Dadurch werden sehr viel höhere Driftgeschwindigkeiten erreicht, als sie in bekannten Halbleiterlaser-Bauelementen der eingangs genannten Art erreicht werden. Darüber hinaus wird verhindert, dass Elektronen aus dem Bereich der aktiven Zone abgezogen werden und es zu Ladungsanhäufungen kommt.

Die Barriereschicht besteht vorzugsweise aus einem Material, welches eine höhere Bandlücke besitzt als das Material der Abstandsschicht. Insbesondere bildet die Barriereschicht eine Barriere für Elektronen, die über die aktive Zone und die Abstandsschicht hinauslaufen.

Eine bevorzugte Weiterbildung des erfindungsgemäßen Halbleiterlaser-Bauelements ist ein SCH-Quantentrog- oder - MQW-Laser bei dem die aktive Zone, Wellenleiterschichten und Deckschichten und die Übergangsschichten Halbleitermaterial aus der Gruppe der III-V-Halbleitermaterialien aufweist.

Besonders bevorzugte Materialien sind hierbei InₓGa₁₋ₓAs_{y}P_{1-y} (0≤x≤1, 0≤y≤1) oder AlₓGa_{y}In_{1-x-y}As (0≤x≤1, 0≤y≤1, x+y≤1 ) für die Deck und Wellenleiterschichten, sowie InₓGa₁₋ₓAS_{y}P_{1-y} (0≤x≤1, 0≤y≤1) oder AlₓGa_{y}In_{1-x-y}As (0≤x≤1, 0≤y≤1, x+y≤1) für die aktive Zone. Vor allem sind Materialien vorgesehen, die verspannt auf dem InP-Substrat oder einer anderen Schicht aufwachsen. Die hochdotierten Übergangsschichten können ebenfalls aus InₓGa₁₋ₓAs_{y}P_{1-y} (0≤x≤1, 0≤y≤1) oder AlₓGa_{y}In_{1-x-y}As (0≤x≤1, 0≤y≤1, x+y≤1) bestehen. Der "Injektoraufbau" der n⁺p⁺-Diode kann in den Wellenleiter integriert werden, wenn der Brechungsindex dieser Übergangsschichten der Funktion eines Wellenleiters angepasst ist, insbesondere wenn der Brechungsindex größer als in den äußeren Deckschichten und kleiner als im Bereich der Quantentopf-Struktur ist.

Vorteilhafterweise ist die Abstandsschicht zwischen der ersten hochdotierten entarteten Übergangsschicht und der Quantentopfstruktur 150 nm bis 10 nm dick und kann aus undotiertem oder schwachdotiertem Halbleitermaterial bestehen. Die hochddotierten entarteten Übergangsschichten sind zwischen 50 nm und 5 nm dick, die niedriger dotierte Barriereschicht kann bis zu 200 nm dick sein.

Bei dem erfindungsgemäßen Aufbau eines Halbleiterlaser-Bauelements werden Löcher in einem sekundären elektrischen Feld beschleunigt und legen somit schneller die kurze Strecke im Wellenleiter bis zur Quantentrog-Struktur zurück. Darüber hinaus wird verhindert, dass Elektronen zu weit über den Bereich der aktiven Zone hinauslaufen.

Das erfindungsgemäße Halbleiterlaser-Bauelement wird im folgenden anhand von 3 Ausführungsbeispielen in Verbindung mit den Figuren 1 bis 3 näher erläutert. Es zeigen:
Figur 1 eine schematische Darstellung einer Schichtstruktur eines ersten Ausführungsbeispiels,
Figur 2 eine schematische Darstellung einer Schichtstruktur eines zweiten Ausführungsbeispiels und
Figur 3 eine schematische Darstellung einer Schichtstruktur eines dritten Ausführungsbeispiels.

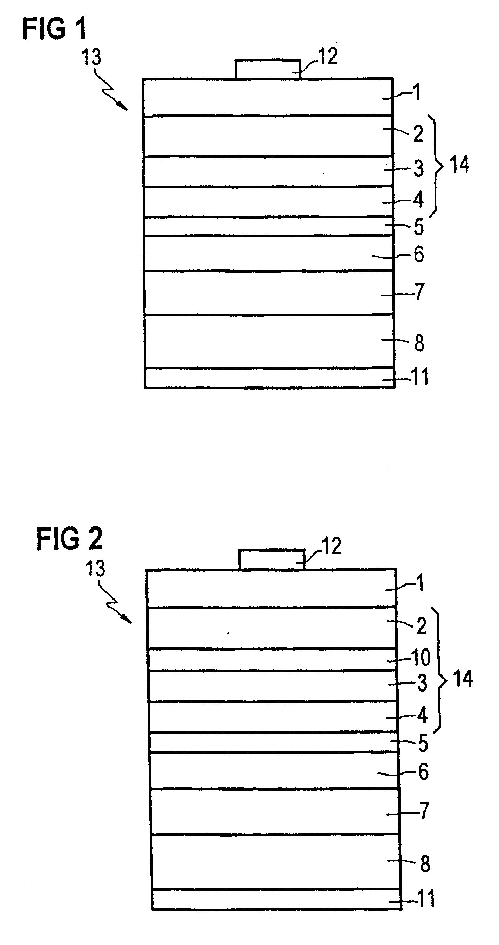

Bei dem Halbleiterkörper 13 von Figur 1 handelt es sich um den Halbleiterkörper eines SCH-Quantentopf-Halbleiterlasers, bei dem auf einem Halbleitersubstrat 8, das beispielsweise aus leitenddotiertem oder semiisolierendem InP besteht, eine erste äußere Deckschicht 7 eines ersten Leitungstyps aufgebracht ist. Diese besteht beispielsweise aus hochdotiertem entartetem InP (n⁺ oder p⁺). Das Halbleitersubstrat weist ggf. denselben Leitungstyp auf wie die erste äußere Deckschicht 7.

Dieser ersten äußeren Deckschicht 7 folgt eine erste Wellenleiterschicht 6, die undotiert, vom ersten Leitungstyp oder von einem diesem entgegengesetzten zweiten Leitungstyp sein kann. Sie besteht beispielsweise aus p-InGaAlAs.

Auf der ersten Wellenleiterschicht 6 ist eine Quantentopfstruktur 5 aufgebracht, beispielsweise bestehend aus undotiertem InGaAs, auf der sich eine dünne Abstandsschicht 4 befindet, die vom zweiten Leitungstyp oder undotiert ist, und z. B. aus p-InGaAlAs besteht.

Der Abstandsschicht 4 schließt sich eine erste hochdotierte entartete Übergangsschicht 3 vom zweiten Leitungstyp an, auf der sich wiederum eine zweite hochdotierte entartete Übergangsschicht 2 vom ersten Leitungstyp befindet. Die erste hochdotierte entartete Übergangsschicht ist beispielsweise eine p⁺-InGaAlAs-Schicht und die zweite hochdotierte entartete Übergangsschicht ist z.B. eine n⁺-InGaAlAs-Schicht. Abschließend ist auf der zweiten hochdotierten entarteten Übergangsschicht 2 eine zweite äußere Deckschicht 1 vom ersten Leitungstyp angeordnet, die beispielsweise aus n-InGaAlAs besteht.

Die Schichtfolge aus erster hochdotierter entarteter Übergangsschicht 3 und zweiter hochdotierter entarteter Übergangsschicht 2 (p⁺n⁺-Diode) dient als Injektor; die Schichtfolge, bestehend aus Abstandsschicht 4, erster hochdotierter entarteter Übergangsschicht 3 und zweiter hochdotierter entarteter Übergangsschicht 2 wirkt als zweite Wellenleiterschicht 14.

Zur elektrischen Kontaktierung des Halbleiterkörpers 13 ist auf einer der ersten äußeren Deckschicht 7 gegenüberliegenden Hauptfläche des Halbleitersubstrats 8 eine erste Kontaktmetallisierung 11 (ohmscher Rückseitenkontakt) und auf einer der zweiten hochdotierten entarteten Übergangsschicht 2 gegenüberliegenden Hauptfläche der zweiten äußeren Deckschicht 1 eine zweite Kontaktmetallisierung 12 (ohmscher Vorderseitenkontakt, z. B. eine Folge Ti/Pt/Au) aufgebracht. Diese Kontaktmetallisierungen 11, 12 bestehen aus in der Halbleitertechnik herkömmlich für die jeweilig eingesetzten Halbleitermaterialien verwendeten Werkstoffe. Die erste Kontaktmetallisierung 11 kann bei Verwendung eines semiisolierenden Halbleitersubstrats 8 direkt an die erste äußere Deckschicht 7 angeschlossen sein.

Bei dem in Figur 2 dargestellten Halbleiterkörper 13 eines SCH-Quantentopf-Halbleiterlasers ist auf einem Halbleitersubstrat 8 (z. B. semiisolierendes InP) analog zu dem Ausführungsbeispiel gemäß Figur 1 eine erste äußere Deckschicht 7 (z. B. n⁺-InP), eine erste Wellenleiterschicht 6 (z. B. p-InGaAlAs), eine Quantentopfstruktur 5 (z. B. InGaAs), eine Abstandsschicht 4 (z. B. p-InGaAlAs) und eine erste hochdotierte entartete Übergangsschicht 3 (z. B. p⁺-InGaAlAs) angeordnet. Im Unterschied zu dem Ausführungsbeispiel von Figur 1 ist hier auf der ersten hochdotierten entarteten Übergangsschicht 3 zunächst eine im Vergleich zur Übergangsschicht 3 niedriger dotierte dünne Barriereschicht 10 vom ersten oder zweiten Leitungstyp aufgebracht. Sie besteht beispielsweise aus n-InGaAlAs. Auf dieser niedriger dotierten Barriereschicht 10 ist dann die zweite hochdotierte entartete Übergangsschicht 2 (z. B.besteheend aus n⁺-InGaAlAs) und auf dieser die zweite äußere Deckschicht 1 (z. B. bestehend aus n⁺-InGaAlAs) aufgebracht. Das Material der Barriereschicht 10 besitzt vorzugsweise eine größere Bandlücke als das Material der Abstandsschicht 4. Insbesondere bildet die Barriereschicht 10 eine Barriere für Elektronen, die über die aktive Zone und die Abstandsschicht 4 hinauslaufen. Als zweite Wellenleiterschicht 14 wirkt hier die Schichtfolge, bestehend aus Abstandsschicht 4, erster hochdotierter entarteter Übergangsschicht 3, Barriereschicht 10 und zweiter hochdotierter entarteter Übergangsschicht 2.

Wie beim Halbleiterkörper 13 gemäß dem Ausführungsbeispiel von Figur 1 ist auch hier das Halbleitersubstrat 8 mit einer ersten Kontaktmetallisierung 11 und die zweite äußere Deckschicht 1 mit einer zweiten Kontaktmetallisierung 12 versehen.

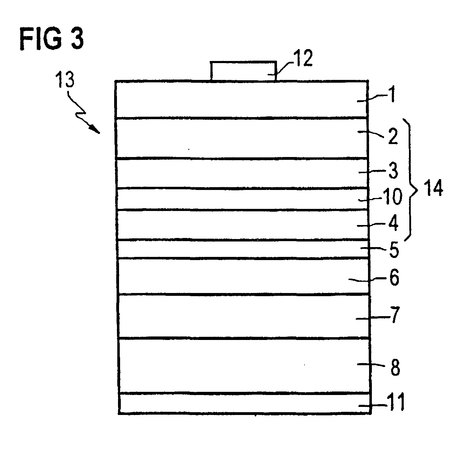

Das Ausführungsbeispiel von Figur 3 unterscheidet sich von dem Ausführungsbeispiel von Figur 1 dadurch, dass auf der Abstandsschicht 4 eine zusätzliche Barriereschicht 10 vom zweiten Leitungstyp (z. B. p-InGaAlAs) aufgebracht ist, der sich die erste hochdotierte entartete Übergangsschicht 3, die zweite hochdotierte entartete Übergangsschicht 2 und die zweite äußere Deckschicht 1 anschließen. Die Barriereschicht 10 besteht vorzugsweise aus einem Material, welches eine größere Bandlücke besitzt als das Material der Abstandsschicht 4. Insbesondere bildet die Barriereschicht 10 eine Barriere für Elektronen die über die aktive Zone und die Abstandsschicht 4 hinauslaufen. Auch hier wirkt die Schichtfolge, bestehend aus der Abstandsschicht 4, Barriereschicht 10, erster 3 und zweiter 2 hochdotierter entarteter Übrgangsschicht als zweite Wellenleiterschicht 14.

Die Beschreibung des erfindungsgemäßen Halbleiterlaser-Bauelements anhand dieser Ausführungsbeispiele ist selbstverständlich nicht als Beschränkung der Erfindung auf diese Ausführungsbeispiele zu verstehen. Erfindungsgemäße Halbleiterlaser können ebenso auf der Basis anderer Mischkristallsysteme ausgebildet sein, wie z.B. Halbleiterkristalle aus den Mischungen der binären Halbleiter GaSb, InSb, InAs, GaAs, AlAs, InP, GaP.
An Stelle der beispielhaft angegebenen p-dotierten äußeren Deckschichten 7,1 können auch n-dotierte äußere Deckschichten 7,1 vorgesehen sein. Die Leitungstypen der Übergangsschichten 3,2, der Abstandsschicht 4 (falls dotiert) und im Ausführungsbeispiel nach Figur 3 der Barriereschicht 10 ist dann entgegengesetzt zu den oben beschriebenen expliziten Beispielen für die Schichtmaterialien.
Als Substrat können neben InP auch Si, GaAs, GaSb oder andere III-V-Halbleiter verwendet werden.

## Patentansprüche

1. Halbleiterlaser-Bauelement mit einem zur Erzeugung einer elektromagnetischen Strahlung geeigneten Halbleiterkörper (13) mit einem Heterostruktur-Aufbau,
**dadurch gekennzeichnet, daß** auf einem Halbleitersubstrat (8) eine zwischen einer ersten äußeren Deckschicht (7) eines ersten Ladungstyps und einer zweiten äußeren Deckschicht (1) des ersten Leitungstyps angeordnete aktive Schichtenfolge mit einer Quantentopfstruktur (5) vorgesehen ist, innerhalb der bei Stromfluß durch den Halbleiterkörper (13) die elektromagnetische Strahlung erzeugt wird, und daß als Ladungsträgerinjektor durch welchen Ladungsträger innerhalb eines internen elektrischen Feldes beschleunigt und dadurch schnell in eine aktive Schichtenfolge injiziert werden, zwischen der aktiven Schichtenfolge und der zweiten äußeren Deckschicht (1) eine erste hochdotierte entartete Übergangsschicht (3) eines dem ersten Leitungstyp entgegengesetzen zweiten Leitungstyps und eine zweite hochdotierte entartete Übergangsschicht (2) des ersten Ladungstyps vorgesehen ist, derart, daß die zweite hochdotierte entartete Übergangsschicht (2) zwischen der ersten hochdotierten entartenten Übergangsschicht (3) und der zweiten äußeren Deckschicht (1) angeordnet ist.

2. Halbleiterlaser-Bauelement nach Anspruch 1, **dadurch gekennzeichnet, dass** die Dicken der entarteten Übergangsschichten (2, 3) jeweils ≥ 5nm und ≤ 50nm sind.

3. Halbleiterlaser-Bauelement nach Anspruch 1 oder 2,
**dadurch gekennzeichnet, dass**
zwischen der ersten hochdotierten entarteten Übergangsschicht (2) und der zweiten hochdotierten entarteten Übergangsschicht (3) eine im Vergleich zu den hochdotierten entarteten Übergangsschichten (2,3) geringer dotierte Barriereschicht (10) eines beliebigen Leitungstyps angeordnet ist, die für Elektronen eine Barriere darstellt.

4. Halbleiterlaser-Bauelement nach einem der Ansprüche 1 bis 3,
**dadurch gekennzeichnet, dass**
zwischen der ersten hochdotierten entarteten Übergangsschicht (3) und der Quantentrogstruktur (5) der aktiven Schichtenfolge eine undotierte Abstandsschicht (4) oder eine im Vergleich zu den Übergangsschichten (2,3) geringer dotierte Abstandsschicht (4) des zweiten Leitungstyps angeordnet ist.

5. Halbleiterlaser-Bauelement nach Anspruch 4,
**dadurch gekennzeichnet, dass**
zwischen der Abstandsschicht (4) und der ersten hochdotierten entarteten Übergangsschicht (3) eine zusätzliche Barriereschicht (10) vom zweiten Leitungstyps angeordnet ist, die eine Barriere für Elektronen darstellt.

6. Halbleiterlaser-Bauelement nach Anspruch 3 oder 5,
**dadurch gekennzeichnet, dass** die Dicke der Barriereschicht (10) kleiner oder gleich 200 nm ist.

7. Halbleiterlaser-Bauelement nach Anspruch 4 oder 5,
**dadurch gekennzeichnet, dass** die Dicke der Abstandsschicht (4) ≥ 10nm und ≤ 150 nm ist.

8. Halbleiterlaser-Bauelement nach einem der Ansprüche 1 bis 7,
**dadurch gekennzeichnet, dass**
zwischen der Quantentopfstruktur (5) und der ersten äußeren Deckschicht (7) eine erste Wellenleiterschicht (6) und
zwischen der Quantentopfstruktur (5) und der zweiten äußeren Deckschicht (1) eine zweite Wellenleiterschicht (14) angeordnet ist.

9. Halbleiterlaser-Bauelement nach Anspruch 8,
**dadurch gekennzeichnet, dass**
die zweite Wellenleiterschicht (14) von den zwischen der Quantentrogstruktur (5) und der zweiten äußeren Deckschicht (1) angeordneten Schichten (2,3,4; bzw. 2,3,4,10) ausgebildet ist.

10. Halbleiterlaser-Bauelement nach Anspruch 9,
**dadurch gekennzeichnet, dass**
die Quantentopfstruktur (5), die Wellenleiterschichten (6,14) und die Deckschichten (1,7) III-V-Halbleitermaterialien aufweisen.

11. Halbleiterlaser-Bauelement nach einem der Ansprüche 1 bis 10, **dadurch gekennzeichnet, dass** die Dotierstoffkonzentration in den entarteten Übergangsschichten (2, 3) ≥ 10¹⁷ cm⁻³ ist.

## Claims

1. Semiconductor laser component having a semiconductor body (13) with a heterostructure construction, which semiconductor body is suitable for generating an electromagnetic radiation,
**characterized in that**, on a semiconductor substrate (8), provision is made of an active layer sequence with a quantum well structure (5), which layer sequence is arranged between a first outer cladding layer (7) of a first charge type and a second outer cladding layer (1) of the first conduction type and within which layer sequence the electromagnetic radiation is generated when current flows through the semiconductor body (13), and **in that**, as charge carrier injector through which charge carriers are accelerated within an internal electric field and thereby injected rapidly into an active layer sequence, a first highly doped degenerate junction layer (3) of a second conduction type, which is opposite to the first conduction type and a second highly doped degenerate junction layer (2) of the first charge type are provided between the active layer sequence the second outer cladding layer (1) in such a way that the second highly doped degenerate junction layer (2) is arranged between the first highly doped degenerate junction layer (3) and the second outer cladding layer (1).

2. Semiconductor laser component according to Claim 1, **characterized in that** the thicknesses of the degenerate junction layers (2, 3) are in each case ≥ 5nm and ≤ 50nm.

3. Semiconductor laser component according to Claim 1 or 2,
**characterized in that**
a barrier layer (10) of an arbitrary conduction type, which barrier layer is doped more lightly in comparison with the highly doped degenerate junction layers (3) and constitutes a barrier to electrons, is arranged between the first highly doped degenerate junction layer (2) and the second highly doped degenerate junction layer (3).

4. Semiconductor laser component according to Claims 1 to 3,
**characterized in that**
an undoped spacer layer (4) or a spacer layer (4) of the second conduction type which is doped more lightly in comparison with the junction layers (2, 3) is arranged between the first highly doped degenerate junction layer (3) and the quantum well structure (5) of the active layer sequence.

5. Semiconductor laser component according to Claim 4,
**characterized in that**
an additional barrier layer (10) of the second conduction type, which barrier layer constitutes a barrier to electrons, is arranged between the spacer layer (4) and the first highly doped degenerate junction layer (3).

6. Semiconductor laser component according to Claim 3 or 5,
**characterized in that**
the thickness of the barrier layer (10) is less than or equal to 200 nm.

7. Semiconductor laser component according to Claim 4 or 5,
**characterized in that** the thickness of the spacer layer (4) ≥ 10nm and ≤ 150nm.

8. Semiconductor laser component according to Claim 1 to 7,
**characterized in that**
a first waveguide layer is arranged between the quantum well structure (5) and the first outer cladding layer (7) and a second waveguide layer (14) is arranged between the quantum well structure (5) and the second outer cladding layer (1).

9. Semiconductor laser component according to Claim 8
**characterized in that**
the second waveguide layer (14) is formed by the layers (2, 3, 4; or 2, 3, 4, 10) arranged between the quantum well structure (5) and the second outer cladding layer (1).

10. Semiconductor laser component according to Claim 9,
**characterized in that**
the quantum well structure (5), the waveguide layers (6, 14) and the cover layers (1, 7) have III-V semiconductor materials.

11. Semiconductor laser component according to one of Claims 1 to 10,
**characterized in that** the dopant concentration in the degenerative junction layers (2, 3) ≥ 10¹⁷ cm⁻³.

## Revendications

1. Composant laser à semiconducteur comprenant un corps (13) à semiconducteur approprié à la production d'un rayonnement électromagnétique ayant un agencement d'hétérostructure,
**caractérisé en ce qu'**il est prévu sur un substrat (8) semiconducteur une succession active de couches, disposées entre une première couche (7) extérieure de finition d'un premier type de conductivité et une deuxième couche (1) extérieure de finition du premier type de conductivité, ayant une structure (5) de puits quantique au sein de laquelle le rayonnement électromagnétique est produit lors du passage de courant dans le corps (13) à semiconducteur, et **en ce qu'**il est prévu comme injecteur de porteurs de charge, par lequel des porteurs de charge sont accélérés dans un champ électrique interne et ainsi injectés rapidement dans une succession active de couches, entre la succession active de couches et la deuxième couche (1) extérieure de finition, une première couche (3) de transition très dopée et dénaturée d'un deuxième type de conductivité opposé au premier type de conductivité, et une deuxième couche (2) de transition très dopée et dégénérée du premier type de conductivité, de façon à ce que la deuxième couche (2) de transition très dopée et dégénérée soit disposée entre la première couche (3) de transition très dopée et dégénérée et la deuxième couche (1) extérieure de finition.

2. Composant laser à semiconducteur suivant la revendication 1, **caractérisé en ce que** les épaisseurs des couches (2, 3) dégénérées de transition sont respectivement ≥ 5 nm et ≤ 50 nm.

3. Composant laser à semiconducteur suivant la revendication 1 ou 2, **caractérisé en ce qu'**entre la première couche (2) très dopée et dégénérée de transition et la deuxième couche (3) très dopée et dégénérée de transition est interposée une couche (10) formant barrière d'un type de conductivité quelconque, qui est moins dopée que les couches (2, 3) très dopées et dégénérées de transition et qui constitue une barrière pour des électrons.

4. Composant laser à semiconducteur suivant l'une des revendications 1 à 3, **caractérisé en ce qu'**entre la première couche (3) de transition très dopée et dégénérée et la structure (5) de puits quantique de la succession active de couches est interposée une couche (4) non dopée de maintien à distance ou une couche (4) de maintien à distance, moins dopée que les couches (2, 3) de transition et du deuxième type de conductivité.

5. Composant laser à semiconducteur suivant la revendication 4, **caractérisé en ce qu'**entre la couche (4) de maintien à distance et la première couche (3) de transition très dopée et dégénérée est interposée à une couche (10) supplémentaire formant barrière du deuxième type de conductivité qui représente une barrière pour les électrons.

6. Composant laser à semiconducteur suivant la revendication 3 ou 5, **caractérisé en ce que** l'épaisseur de la couche (10) formant barrière est inférieure ou égale à 200 nm.

7. Composant laser à semiconducteur suivant la revendication 4 ou 5, **caractérisé en ce que** l'épaisseur de la couche (4) de maintien à distance est ≥ 10 nm et ≤ 150 nm.

8. Composant laser à semiconducteur suivant l'une des revendications 1 à 7, **caractérisé en ce qu'**entre la structure (5) de puits quantique et la première couche (7) extérieure de finition est interposée une première couche (6) de guide d'onde et entre la structure (5) de puits quantique et la deuxième couche (1) extérieure de finition est interposée une deuxième couche (14) de guide d'onde.

9. Composant laser à semiconducteur suivant la revendication 8, **caractérisé en ce que** la deuxième couche (14) de guide d'onde est constituée de couches (2, 3, 4 et 2, 3, 4, 10) interposées entre la structure (5) de puits quantique et la deuxième couche (1) extérieure de finition.

10. Composant laser à semiconducteur suivant la revendication 9, **caractérisé en ce que** la structure (5) de puits quantique, les couches (6, 14) de guide d'onde et les couches (1, 7) de finition comportent des matériaux semiconducteurs III-V.

11. Composant laser à semiconducteur suivant l'une des revendications 1 à 10, **caractérisé en ce que** la concentration de substances de dopage dans les couches (2, 3) dégénérées de transition est ≥ 10¹⁷ cm⁻³.
